# EUROPÄISCHE PATENTSCHRIFT

(11) **EP 0 927 343 B1**
(45) Veröffentlichungstag und Bekanntmachung des Hinweises auf die Patenterteilung: **09.07.2003**
(21) Anmeldenummer: 97944705.9
(22) Anmeldetag: 12.09.1997
(51) Int. Cl.: G01L 1/16, H03H 9/25, G01P 15/10

(54) **MIT AKUSTISCHEN OBERFLÄCHENWELLEN ARBEITENDER SENSORRESONATOR - OFW-RESONATOR - ZUR VERWENDUNG ALS FREQUENZBESTIMMENDE KOMPONENTE EINES OSZILLATORS IN EINER SENSORSCHALTUNG**
SENSOR RESONATOR OPERATING WITH ACOUSTIC SURFACE WAVES - SURFACE WAVE RESONATOR - TO BE USED AS A FREQUENCY-DETERMINING COMPONENT OF AN OSCILLATOR IN A SENSOR CIRCUIT
RESONATEUR DETECTEUR FONCTIONNANT AVEC DES ONDES DE SURFACE ACOUSTIQUES - RESONATEUR A ONDES DE SURFACE - S'UTILISANT COMME CONSTITUANT DETERMINANT LA FREQUENCE D'UN OSCILLATEUR DANS UN CIRCUIT DE DETECTION

(30) Priorität: 20.09.1996 DE 19638634
(43) Veröffentlichungstag der Anmeldung: 07.07.1999
(73) Patentinhaber: SIEMENS AKTIENGESELLSCHAFT, 80333 München (DE)
(72) Erfinder: FISCHERAUER, Gerhard, D-85652 Pliening (DE)
(86) Internationale Anmeldenummer: DE9702055
(87) Internationale Veröffentlichungsnummer: WO98012524

(56) Entgegenhaltungen:
- EP-A- 0 416 160
- US-A- 3 878 477
- US-A- 4 254 387
- US-A- 4 467 235
- AVRAMOV I D ET AL: "A SURFACE-ACOUSTIC-WAVE COMB SPECTRUM OSCILLATOR FOR SENSOR APPLICATIONS" IEEE TRANSACTIONS ON ULTRASONICS, FERROELECTRICS AND FREQUENCY CONTROL, Bd. 38, Nr. 4, 1.Juli 1991, Seiten 334-336, XP000216470 in der Anmeldung erwähnt

## Beschreibung

Die vorliegende Erfindung betrifft einen mit akustischen Oberflächenwellen arbeitenden Resonator.

Aus US-A-4,467,235 ist ein Sensorresonator bekannt, der zwei Resonanzräume aufweist, wobei einer dieser Resonanzräume einmodig, der andere Resonanzraum mehrmodig ausgebildet ist. Es bildet sich eine Interferenz der einen Resonanzfrequenz des einmodigen Resonanzraums mit den Resonanzfrequenzen des mehrmodigen Resonanzraums aus. Zur Auswertung des Sensorsignals wird bei einer bestimmten fixierten Frequenz die Amplitude des Interferenzsignals gemessen (siehe Figur 5 und dazugehörige Beschreibung in Spalte 5, Zeilen 47 bis 59).

Aus US-A-4,254,387 ist ein Resonatorfilter bekannt, welches einen Resonanzraum aufweist, der mehrere Moden ausbilden kann. Die Elektroden der Interdigitalwandler sind dabei so im Resonanzraum angeordnet, daß sie nur mit einer einzigen Mode koppeln können, während sich für die anderen Moden eine Signalauslöschung aufgrund unterschiedlicher relativer Anordnung zur Phasenlage der jeweiligen resonanten Mode ergibt. Das Filter erzeugt dabei ein enges Passband bei der Resonanzfrequenz, mit der der Interdigitalwandler koppelt. Die beiden anderen Moden haben dabei keinen Einfluß auf das den Filter passierende Signal.

Mit OFW-Bauelementen arbeitende Sensoranordnungen, bei denen ein als Sensor ausgebildetes OFW-Bauelement in einem Oszillatorkreis liegt, sind bekannt. Dazu wird auf IEEE Transactions on Ultrasonics, Ferroelectrics and Frequency Control, Vol. 38, No. 4, July 1991, Seiten 334 bis 336 und Analytical Chemistry, Vol. 51, No. 9, August 1979, Seiten 1458 bis 1475 verwiesen. Bei einem in dieser Druckschrift speziell beschriebenen Oszillator liegt im Oszillatorkreis als frequenzbestimmende Komponente eine breitbandige OFW-Verzögerungsleitung. Eine derartige Verzögerungsleitung wird durch einen Eingangs- und einen Ausgangsinterdigitalwandler gebildet, zwischen denen in der akustischen Laufstrecke ein auf eine bestimmte zu detektierende Größe ansprechende Einrichtung vorgesehen ist. Damit können dann physikalische Effekte, wie beispielsweise eine Gaskonzentration, eine mechanische Kraft oder ein elektrisches Feld detektiert werden. Die physikalische Größe beeinflußt die Geschwindigkeit der sich zwischen dem Eingangs- und dem Ausgangsinterdigitalwandler ausbreitenden akustischen Oberflächenwelle, womit wiederum eine Verschiebung der Oszillatorfrequenz verbunden ist.

Dabei sollte die Oszillatorfrequenz im Idealfall allein von dem im Oszillatorkreis liegenden OFW-Bauelement bestimmt werden. In der Praxis hat jedoch auch die elektronische Schaltung, insbesondere deren aktiver Teil in Form eines Verstärkers, einen nicht vernachlässigbaren Einfluß.

Beispielsweise verändern Temperaturschwankungen, Alterung oder Leistungsschwankungen im Oszillatorkreis die Übertragungsphase der elektronischen Schaltung. Dies führt zu einer Verschiebung der Oszillatorfrequenz, die als vom OFW-Sensorbauelement detektierter Meßeffekt fehlinterpretiert wird.

Um derartige Fehlinterpretationen zu vermeiden, können OFW-Bauelemente verwendet werden, deren Übertragungsphase als Funktion der Frequenz sehr steil im Vergleich zu derjenigen der elektronischen Schaltung verläuft. Dadurch schwingt der Oszillator stabil auf der Frequenz des OFW-Sensorbauelementes, weil Phasenschwankungen im elektronischen Zweig durch sehr kleine Frequenzverschiebungen mit der damit zusammenhängenden Veränderung in der Übertragungsphase des Sensorbauelementes kompensiert werden. Nachteilig dabei ist jedoch, daß ein Effekt bestimmter Größe im Meßfall eine um so kleinere Frequenzänderung bewirkt, je größer die Phasensteilheit des OFW-Sensorbauelementes ist. Dadurch wird die Auflösung der Sensoranordnung begrenzt.

Der Temperaturempfindlichkeit der Schaltungselektronik; die eine der größten Störursachen darstellt, kann mit einer Thermostabilisierung der gesamten Schaltungsanordnung begegnet werden. Nachteilig dabei ist jedoch ein hoher apperativer Aufwand, ein Energieverbrauch für Heizleistung sowie eine Vergrößerung des Volumens des Sensorsystems. Die letztgenannte Volumenvergrößerung ist insbesondere für Sensorarrays ungünstig.

Die Übertragungsphase der elektronischen Schaltung kann mit Regelschaltungen konstant gehalten werden. Dies bedingt jedoch einen hohen schaltungstechnischen Aufwand und eine Vergrößerung des Volumens des Sensorsystems - wiederum ungünstig für Sensorarrays - sowie eine nicht zu eliminierende Auswirkung von Störeffekten auf die Elemente der Regelschaltung.

Mit Regelschaltungen kann ebenfalls verhindert werden, daß der Verstärker im Oszillator in Sättigung betrieben wird und dadurch Leistungsschwankungen oder Prequenzänderungen zu Phasenschwankungen führen. Auch damit ist jedoch wiederum ein hoher schaltungstechnischer Aufwand und eine Vergrößerung des Volumens des Sensorsystems verbunden.

Der vorliegenden Erfindung liegt die Aufgabe zugrunde, ein OFW-Bauelement in Form eines Resonators für eine Sensoranordnung der in Rede stehenden Art anzugeben, mit dem der oben beschriebene Einfluß der Schaltungselektronik ausgeschaltet werden kann.

Diese Aufgabe wird bei einem OFW-Resonator der eingangs genannten Art erfindungsgemäß durch die Maßnahme des Patentanspruchs 1 gelöst.

Weiterbildungen der Erfindung sind Gegenstand von abhängigen Ansprüchen.

Die Erfindung wird nachfolgend anhand von in den Figuren der Zeichnung dargestellten Ausführungsbeispielen näher erläutert. Es zeigt:
- Figur 1: ein schematisches Blockschaltbild eines Oszillators mit einem OFW-Bauelement als frequenzbestimmende Komponente im Oszillatorkreis;
- Figur 2: eine schematische Darstellung eines mehrmodigen OFW-Resonators;
- Figur 3: ein schematisches Schaltbild eines Oszillators nach Figur 1 mit einem OFW-Resonator nach Figur 2 sowie einer Frequenzumschaltung zwischen zwei Resonatormoden und damit zwei Oszillatorfreguenzen; und
- Figur 4: ein schematisches Blockschaltbild zur Erläuterung einer Beschaltung eines einen mehrmodigen OFW-Sensor enthaltenden Oszillators entsprechend Figur 1.

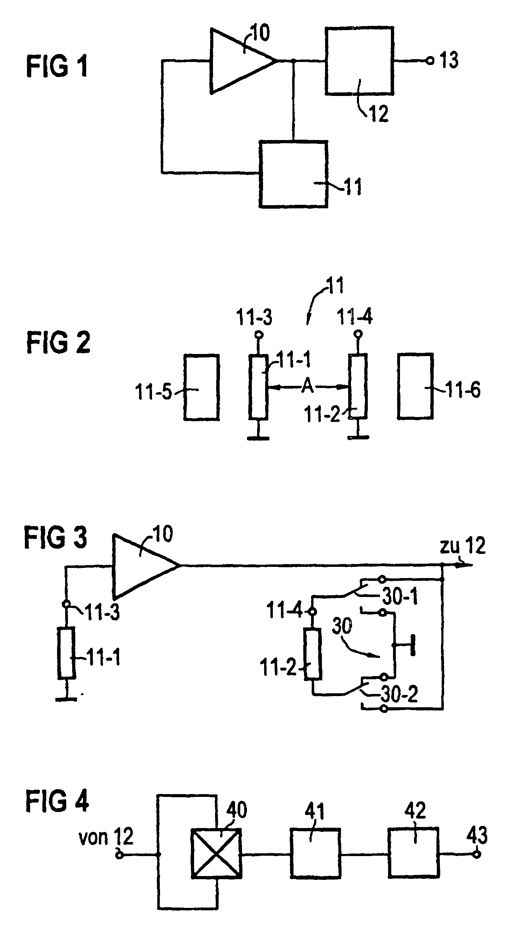

Gemäß Figur 1 sind die grundsätzlichen Komponenten eines Oszillators für eine Sensoranordnung der in Rede stehender Art ein Verstärker 10, in dessen Rückkopplungszweig ein frequenzbestimmendes OFW-Bauelement 11 liegt. Diese beiden Komponenten bilden einen Oszillator, wie er aus der oben genannten Druckschrift an sich bekannt ist. Das Oszillatorausgangssignal wird über einen Auskoppelkreis 12 auf einen Ausgang 13 gekoppelt.

Ein wesentliches Merkmal der Erfindung besteht nun darin, daß ein OFW-Resonator mit mehreren akustischen Moden als Sensor verwendet und als Sensor-Ausgangssignal der Frequenzabstand zwischen mehreren dieser Moden ausgewählt wird.

Figur 2 zeigt eine mögliche Ausführungsform eines derartigen Resonators. Es handelt sich um einen Zweitor-Resonator mit einem Eingangs-Interdigitalwandler 11-1 und elektrischem Eingang 11-3, einem Ausgangs-Interdigitalwandler 11-2 mit elektrischem Ausgang 11-4 und jeweils einem Reflektor 11-5 bzw. 11-6 auf voneinander abgewandten Seiten der Interdigitalwandler 11-1, 11-2, welche die akustische Resonatorlaufstrecke abschließen.

Der Abstand zwischen dem Eingangs-Interdigitalwandler 11-1 und dem Ausgangs-Interdigitalwandler 11-2, welcher in Figur 2 mit A bezeichnet ist, ist so gewählt, daß mehrere longituginale Moden bzw. Resonanzspitzen in der Übertragungsfunktion auftreten. Mit wachsendem Abstand A treten immer mehr Moden bzw. Resonanzspitzen in der Übertragungsfunktion auf.

Der Abstand A nach Figur 2 kann beispielsweise so gewählt werden, daß sich zwei Moden bzw. Resonanzspitzen in der Übertragungsfunktion ergeben, die betragsmäßig im wesentlichen gleich sind, sich in der Phase jedoch um 180° voneinander unterscheiden - dieser Phasenunterschied gilt auch für den jeweils nächstliegenden Nachbarn bei mehr als zwei Moden bzw. Resonanzspitzen in der Übertragungsfunktion.

Im schematischen Schaltbild nach Figur 3, in dem gleiche Komponenten wie in den Figuren 1 und 2 mit gleichen Bezugszeichen versehen sind, ist ein Ausführungsbeispiel dargestellt, bei dem für einen zweimodigen OFW-Resonator im frequenzbestimmenden Kreis eines Oszillators eine Umschaltung zwischen zwei den Moden des Resonators entsprechenden Oszillatorfrequenzen möglich ist. In Figur 3 ist der Einfachheit halber für einen dem Resonator nach Figur 2 entsprechenden Resonator lediglich der Eingangs- und Ausgangs-Interdigitalwandler 11-1, 11-3 bzw. 11-2, 11-4 dargestellt. Über einen Umschalter 30 mit zwei Schalterkontakten 30-1, 30-2 ist eine Umschaltung um 180° entsprechend dem Phasenunterschied von 180° der beiden Moden bzw. Resonanzspitzen in der Übertragungsfunktion des OFW-Resonators möglich. Es handelt sich somit um eine Auswerteschaltung, die es ermöglicht durch einfaches Umlegen der Schalterkontakte 30-1, 30-2 des Umschalters 30 den Oszillator wahlweise auf der einen oder der anderen der zwei OFW-Resonanzfrequenzen des zweimodigen Resonators schwingen zu lassen. Der Unterschied zwischen den beiden Resonanzfrequenzen ist dabei der mittleren akustischen Wellengeschwindigkeit im Resonanzraum des OFW-Resonators proportional und der effektiven Länge des Resonanzraumes umgekehrt proportional.

Anstelle eines Umschalters mit Schalterkontakten sind auch elektrische Schalter oder Verstärker mit invertierendem und nicht invertierendem Eingang möglich.

Unter praktisch ohne weiteres zu erfüllenden Bedingungen, daß die Schaltungselektronik breitbandig ist (und daher bei den beiden OFW-Resonanzfrequenzen dieselbe Übertragungsphase aufweist) und
Störeffekte wie Temperaturschwankungen, Alterungsdrift der Elektronik oder Leistungsschwankungen im Oszillatorkreis sich in einem Zeitmaßstab auswirken, der die Dauer eines Meßzyklus (Messung der einen Oszillatorfrequenz, Umlegen des Schalters, Messung der anderen Oszillatorfrequenz) überschreitet, gibt der Unterschied der Resonator-Resonanzfrequenzen auch den Unterschied der Oszillatorfrequenzen bei den beiden Schalterstellungen wieder. Ersichtlich hängt der Frequenzunterschied, der als Ausgangssignal einer Sensoranordnung zu betrachten ist, nur von den Eigenschaften der akustischen Welle im OFW-Resonator, nicht jedoch von der Schaltungselektronik ab.

Die vorgenannte Lösung zur Minimierung des Einflusses der Schaltungselektronik auf das Ausgangssignal eines Sensors besitzt folgende Vorteile:
Es ist lediglich ein Umschalter erforderlich, was praktisch keinen erhöhten schaltungstechnischen Aufwand bedeutet. Daher sind billige und sehr kompakte Systeme möglich.

Der Aufwand der Schaltungselektronik kann beschränkt werden; sie muß nicht temperaturstabil oder alterungsbeständig sein, weil diese Effekte an sich eliminiert werden. Es könnten daher sehr einfache Schaltungsausführungsformen mit z. B. nur einem oder zwei Transistoren als Verstärker realisiert werden.

Darüber hinaus können die Anforderungen an den steilen Verlauf der Übertragungsphase als Funktion der Frequenz des OFW-Resonators gelockert werden, womit ggf. eine bessere Auflösung des Sensorsystems erreichbar ist.

Wird die effektive Länge des Resonanzraums im OFW-Resonator entsprechend dem Abstand A zwischen den Interdigitalwandlern 11-1, 11-2 in Figur 2 weiter erhöht, so sind Resonatoren mit mehr als zwei Moden, beispielsweise drei Moden realisierbar. Dabei ist der Frequenzabstand der beiden äußeren Resonanzspitzen des OFW-Resonators wiederum der mittleren akustischen Wellengeschwindigkeit im Resonanzraum proportional und der effektiven Lange des Resonanzraumes umgekehrt proportional.

Fügt man einen derartigen OFW-Resonator in den Rückkopplungszweig eines geeignet ausgebildeten Oszillators ein, so ergibt sich eine gleichzeitige Oszillation bei den beiden Frequenzen, die den beiden äußeren Resonanzspitzen des OFW-Resonators entsprechen. Diese gleichzeitige Oszillation bei zwei Frequenzen ist durch geeignete Schaltungsmaßnahmen, speziell durch Einführen nichtlinearer Schaltungsteile, realisierbar. Bei der mittleren Resonanzspitze findet keine Oszillation statt, weil dabei die Phasenbeziehung von 180° für die Schwingbedingung nicht erfüllt ist. Hinsichtlich spezieller schaltungstechnischer Ausgestaltungen des Resonators mit nichtlinearen Schaltungsteilen wird auf die eingangs genannte Druckschrift verwiesen.

Auch bei einer Ausführungsform der vorstehend beschriebenen Art wird der Abstand der Oszillatorfrequenzen unter der praktisch ohne weiteres zu erfüllenden Bedingung, daß die Schaltungselektronik breitbandig ist und daher die OFW-Resonanzfrequenzen dieselbe Übertragungsphase aufweisen, durch die vorgenannte Bedingung hinsichtlich der mittleren akustischen Wellengeschwindigkeit im Resonanzraum und dessen effektiver Länge beschrieben. Auch dabei hängt der Frequenzunterschied, der als Ausgangssignal einer Sensoranordnung zu betrachten ist, nur von den Eigenschaften der akustischen Welle im OFW-Resonator, nicht jedoch von der Schaltungselektronik ab.

Zur praktischen Meßwerterfassung ist eine Schaltungsanordnung verwendbar, wie sie im schematischen Schaltbild nach Figur 4 dargestellt ist. Dabei wird das vom Auskoppelkreis 12 über den Ausgang 13 nach Figur 1 kommende Oszillatorausgangssignal auf einen Mischer 40 gegeben, an dessen Ausgang die beiden Oszillatorfrequenzen entsprechend den äußeren Resonanzspitzen des OFW-Resonators, deren höhere harmonische, ein Gleichanteil und die Differenzfrequenz der beiden Oszillatorfrequenzen zur Verfügung stehen. Über einen nachfolgenden Hochpaß 41 und einen diesem nachgeschalteten Tiefpaß 42 werden der Gleichanteil sowie die hochfrequenten Anteile ausgefiltert, so daß an einem Ausgang 43 die Differenzfrequenz der beiden Oszillatorfrequenzen mit einem nicht dargestellten einfachen Frequenzzähler gemessen werden können.

Die vorstehend beschriebene Ausführungsform hat über die bereits oben angeführten Vorteile den weiteren Vorzug, daß die Differenzfrequenz unmittelbar gemessen werden kann. Dadurch werden beliebig schnelle Schwankungen der Übertragungsphase der Schaltungselektronik aus dem Ausgangssignal eliminiert.

## Patentansprüche

1. Sensoranordnung
- mit einem mit akustischen Oberflächenwellen arbeitenden Resonator - OFW-Resonator - als frequenzbestimmende Komponente eines Oszillator,
- wobei der OFW-Resonator (11) als Sensor für Größen, beispielsweise mechanischer, elektrischer, magnetischer, thermischer oder chemischer Natur, ausgebildet ist,
- wobei der OFW-Resonator (11) mehrmodig ausgebildet ist
- wobei der Frequenzabstand zweier Moden als Sensorsignal auswertbar ist.

2. Sensoranordnung nach Anspruch 1,
bei der der OFW-Resonator als Zweitor-Resonator (11) ausgebildet ist, mit einem Eingangs- und einem Ausgangs-Interdigitalwandler (11-1, 11-2) und jeweils einem die akustische Laufstrecke abschließenden Reflektor (11-5, 11-6) auf voneinander abgewandten Seiten der Interdigitalwandler (11-1, 11-2) und einem solchen Abstand (A) der Interdigitalwandler (11-1, 11-2), daß sich wenigstens zwei sich in ihrer Phasenlage um 180° unterscheidende Resonatormoden ausbilden.

3. Sensoranordnung nach Anspruch 1 oder 2,
bei der im Oszillatorkreis ein Phasenumschalter (30, 30-1, 30-2) zur Umschaltung auf jeweils eine von sich um 180° unterscheidenden Resonatormoden vorgesehen ist.

4. Sensoranordnung nach einem der vorangehenden Ansprüche,
mit einem dreimodigen OFW-Resonators, bei der der Oszillator so ausgebildet ist, daß er auf mindestens zwei Oszillatorfrequenzen gleichzeitig schwingt.

## Claims

1. Sensor arrangement
- having a resonator - SAW resonator - which operates with surface acoustic waves as the frequency-determining component for an oscillator,
- with the SAW resonator (11) being in the form of a sensor for variables, for example of a mechanical, electrical, magnetic, thermal or chemical nature,
- with the SAW resonator (11) being in the form of a multimode resonator, and
- in which the frequency separation between two modes can be evaluated as a sensor signal.

2. Sensor arrangement according to Claim 1,
in which the SAW resonator is in the form of a two-port resonator (11), having an input interdigital transducer (11-1) and an output interdigital transducer (11-2), and in each case having a reflector (11-5, 11-6), which terminates the acoustic path, on sides of the interdigital transducers (11-1, 11-2) which face away from one another, and with the interdigital transducers (11-1, 11-2) being separated by a distance (A) such that at least two resonator modes are formed, whose phase angles differ by 180°.

3. Sensor arrangement according to Claim 1 or 2,
in which a phase switch (30, 30-1, 30-2) for switching to in each case one of resonator modes which differ by 180° is provided in the oscillator circuit.

4. Sensor arrangement according to one of the preceding claims having a three-mode SAW resonator, in which the oscillator is designed such that it oscillates simultaneously at at least two oscillator frequencies.

## Revendications

1. Dispositif détecteur
- comprenant un résonateur fonctionnant avec des ondes de surface acoustiques - résonateur à ondes de surface - comme constituant déterminant la fréquence d'un oscillateur,
- le résonateur à ondes de surface (11) étant conçu comme détecteur de paramètres, par exemple de nature mécanique, électrique, magnétique, thermique ou chimique,
- le résonateur à ondes de surface (11) étant conçu de manière multimodale
- l'écart de fréquences de deux modes pouvant être évalué comme signal de détecteur.

2. Dispositif détecteur selon la revendication 1,
dans lequel le résonateur à ondes de surface est conçu comme résonateur biporte (11), comportant un convertisseur interdigital (11-1, 11-2) d'entrée et de sortie et un réflecteur (11-5, 11-6) terminant respectivement le trajet acoustique sur les faces opposées du convertisseur interdigital (11-1, 11-2) et un espacement (A) des convertisseurs interdigitaux (11-1, 11-2) tels qu'au moins deux modes de résonateur se différenciant de 180° dans leur position de phase se forment.

3. Dispositif détecteur selon la revendication 1 ou 2, dans lequel un commutateur de phases (30, 30-1, 30-2) est prévu dans le circuit de l'oscillateur pour commuter respectivement sur l'un des modes résonateur se différenciant de 180°.

4. Dispositif détecteur selon l'une des revendications précédentes, comprenant un résonateur à ondes de surface trimodale, dans lequel l'oscillateur est conçu de sorte à vibrer simultanément sur au moins deux fréquences d'oscillateur.
